Europäisches Patentamt

European Patent Office

Office européen des brevets

(11) Publication number: **0 249 256 B1**

# EUROPEAN PATENT SPECIFICATION

(45) Date of publication of patent specification: **22.01.92**  (51) Int. Cl.5: **H01L 23/52**, H01L 23/48

(21) Application number: **87200642.4**

(22) Date of filing: **06.04.87**

(54) **A semiconductor device with an aluminium interconnect layer containing a small percentage of vanadium.**

(30) Priority: **14.04.86 US 851648**

(43) Date of publication of application:
**16.12.87 Bulletin 87/51**

(45) Publication of the grant of the patent:
**22.01.92 Bulletin 92/04**

(84) Designated Contracting States:
**DE FR GB IT NL**

(56) References cited:
**EP-A- 0 082 012**
**EP-A- 0 161 026**
**EP-A- 0 179 369**
**US-A- 4 017 890**
**US-A- 4 525 734**

**THIN SOLID FILMS, vol. 114, no. 3, April 1984, pages 271-284, Elsevier Sequoia, Lausanne, CH; T.G. FINSTAD et al.: "Phase formation and diffusion in V/A1 thin film couples prepared under varying deposition conditions"**

**PATENT ABSTRACTS OF JAPAN, vol. 10, no. 184 (E-415)[2240], 27th June 1986; & JP-A-61 32 444**

(73) Proprietor: **N.V. Philips' Gloeilampenfabrieken**
**Groenewoudseweg 1**
**NL-5621 BA Eindhoven(NL)**

(72) Inventor: **Dirks, Albertus Gerhardus**
**c/o INT. OCTROOIBUREAU B.V. Prof. Holst-**
**laan 6**
**NL-5656 AA Eindhoven(NL)**
Inventor: **Towner, Janet Maureen**
**c/o INT. OCTROOIBUREAU B.V. Prof. Holst-**
**laan 6**
**NL-5656 AA Eindhoven(NL)**

(74) Representative: **Rensen, Jan Geert et al**
**Internationaal Octrooibureau B.V. Prof. Hol-**
**stlaan 6**
**NL-5656 AA Eindhoven(NL)**

EP 0 249 256 B1

# Description

This invention relates to a semiconductor device having a body and a patterned electrically conductive layer consisting of aluminium with a small percentage of vanadium on a surface of said body and a method of producing it.

Aluminium is the principal conductive material employed for electrical interconnection in semiconductor devices. The top interconnection layer in an integrated circuit nearly always consists of an aluminium alloy. The reasons for the predominance of aluminium includes low resistivity, good adherence to silicon dioxide, low cost, ease in bonding, and good etchability.

One of the main phenomena that cause an interconnect layer to degrade is electromigration in which atoms of the interconnect physically change location as current passes through the interconnect. The circuit resistance increases. An open-circuit failure may occur. If the interconnect layer consists of pure aluminium, failure through electromigration typically occurs much faster than desirable.

One or more impurities are often used in the aluminium to inhibit electromigration. For example, an aluminium alloy formed with 1% silicon by weight and from 0.5% to 4% copper by weight has considerably better electromigration resistance than pure aluminium, see J. Towner, "Electromigration Testing of Thin Films at the Wafer Level," Solid State Technology, Vol. 27, Oct. 1984, pp. 197-200. Copper, however, does not form a volatile halide. This limits the usage of copper in situations where it is desirable to etch the interconnect with a halogen-based plasma.

In U.S. Patents 4,154,874 and 4,017,890, H. Howard et al specify that electromigration can be reduced by using a multi-phase aluminium alloy in which there are regions containing one or more intermetallic compounds formed with aluminium and at least one transition metal. The intermetallic material consists of at least 2% of the interconnect by weight. The device and process of Howard et al, which corresponds to the preambles of claims 1 and 4, involves depositing aluminium and the transition metal(s) on a body such as a semiconductor device, annealing the structure at a sufficiently high temperature to produce the intermetallic compound(s), and then removing portions of the resulting alloy layer to define the interconnect in a multi-phase crystal-structure.

One of the transition metals studied by Howard et al is vanadium which (according to Howard et al) forms $VAl_7$ and $V_4Al_{23}$ as intermetallic species. The work with vanadium is of interest because it forms a volatile halide and is therefore quite suitable to plasma etching. However, it appears that the resistivity of the Al-V alloy of Howard et al would be too high for numerous future integrated circuit applications.

In accordance with the invention, the structure with the patterned electrically conductive layer which consists of aluminium with a small percentage of vanadium is characterized in that the layer contains 0,01 - 0,3% vanadium by weight which is in solid solution distributed uniformly throughout the layer. The structure is created by depositing a layer of aluminium and vanadium in the necessary proportions on the body after which the layer is patterned and annealed.

The present vanadium-containing aluminium alloy has excellent electromigration resistance, particularly at the 0.3% vanadium level. The worst-case resistivity is only about 30% greater than that of pure aluminium, making the alloy quite acceptable for integrated circuit usage. The upper surface of the patterned layer is considerably smoother than that formed with pure aluminium or an aluminium alloy having a small amount of silicon. The small percentage of vanadium should not affect substrate adhesion or bondability. Also, the present alloy can be readily etched with halogen-based plasmas.

The invention will be described more fully, by way of example, with reference to the drawing, in which:

Fig. 1 is a perspective view of a structure having a patterned interconnect layer consisting of aluminium with a small fraction of vanadium according to the invention,

Figs. 2a, 2b, 2c, and 2d are cross-sectional views representing steps in manufacturing the structure of Fig. 1 and

Figs. 3a and 3b are graphs respectively showing the variation of resistivity and median time to failure as a function of vanadium concentration in aluminium interconnect layers.

Like reference symbols are employed in the figures and the description of the preferred embodiments to represent the same or very similar item or items.

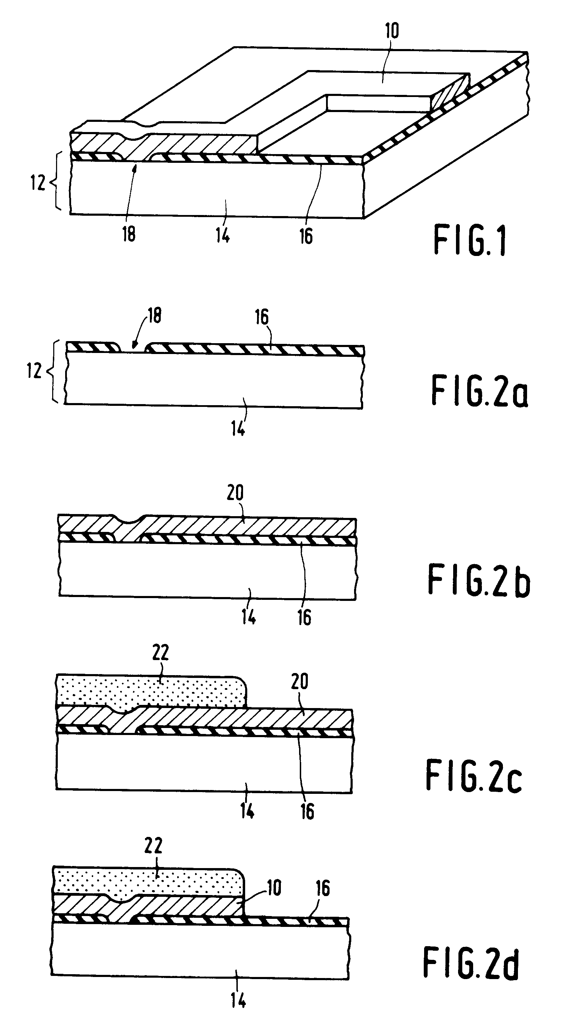

Fig. 1 illustrates a structure in which a patterned electrically conductive interconnect layer 10 lies on the upper surface of a body 12 consisting of a monocrystalline silicon substrate 14 and an overlying layer 16 of silicon dioxide. Substrate 14 may contain various N-type and P-type regions (not shown). Interconnect layer 10 contacts certain of these doped regions by way of apertures through insulating layer 16 of which Fig. 1 indicates one such aperture 18. A thin layer (not shown) of a barrier metal such as tungsten or titanium-tungsten may lie in aperture 18 between layer 10 and substrate 14.

Interconnect layer 10 consists of aluminium with 0.01 % - 0.3% vanadium by weight. The two metals are substantially in a single-phase crystal structure, sometimes referred to as a solid solution, in which the vanadium is distributed substantially uniformly throughout the aluminium. Layer 10 contains essentially no intermetallic compounds formed with vanadium and aluminium.

More particularly, the equilibrium solid solubility of vanadium in aluminium is about 0.13 wt % V at 450°C. The components of layer 10 unqualifiedly form a single phase if the vanadium concentration is about 0.13 wt % or less. There is no significant change if the amount of vanadium rises to 0.3 wt %. For example, no V-Al intermetallic compounds were clearly discernible during transmission electron microscope analysis of a post-annealed (35 minutes at 450°C) sample of conductor 10 containing about 0.2 wt % V. Little intermetallic compound formation was observed in a post-annealed (35 minutes at 450°C) sample having about 0.4 wt % V. From this, it appears that the aluminium and vanadium in layer 10 are essentially in a single crystal phase for the 0.13 - 0.3 wt % V range.

The single-phase structure in layer 10 may result in a higher resistivity than that which would exist if the crystal structure were multi-phase with one or more intermetallic compounds present. However, the single phase appears to reduce susceptability to corrosion and to facilitate etching with halogen-based plasmas.

Layer 10 may also contain up to 4 wt % silicon distributed substantially uniformly throughout the aluminium and vanadium. If any silicon is present, the amount is usually 1 wt %. Although silicon does not form a silicide with aluminium, the silicon present in layer 10 makes it easier to form intermetallic compounds. Nonetheless, it appears that layer 10 contains little, if any, Al-V-Si compounds when the amounts of vanadium and silicon are respectively no more than 0.3 wt & and 1 wt %.

Figs. 2a - 2d illustrate how the structure of Fig. 1 is fabricated. The starting material is body 12 in which oxide layer 16 is formed according to conventional thermal oxidation or deposition techniques along the top of substrate 14. Aperture 18 is cut through dielectric 16 using conventional masking and etching processes to produce the structure shown in Fig. 2a. The barrier metal layer, if present, is then formed according to conventional techniques.

The structure is placed in the deposition chamber of a sputtering apparatus such as a multi-pass DC planar magnetron system. The chamber is pump o a low pressure (e.g., $7 \times 10^{-5}$ Pa) and back filled with argon to a maximum pressure of 25 Pa. The chamber pressure is preferably about 0.2 Pa. Aluminium and vanadium are then sputtered from a single deposition source at a target power of 1.6 kilowatts to form a conductive layer 20 consisting of aluminium with a small amount of vanadium at a selected value in the range from 0.01 - 0.3 wt %. If the final alloy is to contain some silicon, it is also provided from the deposition source. The thickness of layer 20 is about 0.5 micron. The structure appears as indicated in Fig. 2b.

After removing the structure from the sputtering deposition chamber, standard photolithographic techniques are employed to form a photoresist mask 22 on the top layer 20 as indicated in Fig. 2c. The exposed portion of layer 20 is removed with a conventional Cl containing plasma to define patterned interconnect layer 10 as depicted in Fig. 2d. Mask 22 is removed to produce the structure of Fig. 1.

The structure is now annealed for 10 to 480 minutes at a temperature in the range from 400 to 500°C. The annealing step is preferably done at 450°C for 30 - 35 minutes. The anneal stabilizes the grain structure in layer 10, lowers its resistivity, and ensures good contact to substrate 14.

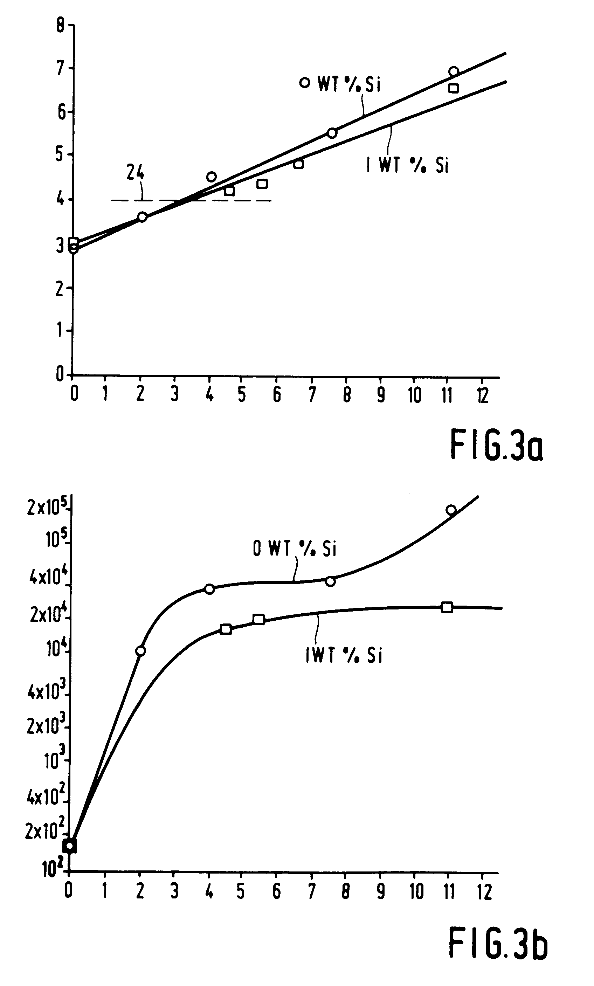

Fig. 3a shows experimental data for the variance of resistivity as a function of vanadium concentration for samples of conductor 10 having 0 wt % Si and 1 wt % Si. A resistivity of 4 microohm-centimeters, represented by dashed line 24, was pre-established as the maximum value acceptable for future integrated circuit applications. Otherwise, the loss in speed for an Al-V alloy compared to an Al alloy not containing vanadium would be too great. With reference to the data shown in Fig. 3a, the maximum acceptable concentration of vanadium in the alloy (i.e., layer 10 or 20) was around 0.3 wt % vanadium.

Life testing was performed on samples of conductor 10 having a length of 2000 microns and a width of 4 microns to determine electromigration resistance. In order to minimize testing time, no passivation coating was used in the samples. The life tests were performed in accordance with the procedure described in Towner, cited above. Fig. 3b shows test results for Al-V alloys having 0 wt % Si and 1 wt % Si. As indicated there, the median time to failure rises from a relatively low level when no vanadium is present to approximately a plateau near 0.3 wt % vanadium.

While the invention has been described with reference to particular embodiments, this description is solely for the purpose of illustration and is not to be construed as limiting the scope of the invention claimed below. The aluminium and vanadium could be deposited by evaporative techniques. Multiple deposition sources could be employed. Elements other than vanadium and silicon may be in the interconnect layer as long as it is substantially aluminium. The anneal could be performed before the patterning step. Thus, various modifications, changes, and applications may be made by those skilled in the art without departing from the true scope of the invention as defined by the appended claims.

**Claims**

1. A semiconductor device having a body and a patterned electrically conductive layer consisting of aluminium with a small percentage of vanadium on a surface of said body, characterized in that the layer contains 0,01 - 0,3% vanadium by weight which is in solid solution distributed uniformly throughout the layer.

2. A device as in Claim 1, characterized in that the layer contains no more than 0,13% vanadium by weight.

3. A device as in Claim 1 or 2, characterized in that the layer contains up to 4% silicon by weight.

4. A method of producing a semiconductor device according to Claim 1 in which the electrically conductive layer consisting of aluminium with a small percentage of vanadium is deposited on a surface of said body, after which the layer is patterned and annealed, characterized in that the layer is deposited by sputtering aluminium and vanadium from a single source in such a way that the layer as it is deposited contains 0,01 - 0,3% vanadium by weight, and in that the layer is annealed at a temperature in the range from 400°C to 500°C for a time in the range from 10 minutes to 480 minutes.

**Revendications**

1. Dispositif semi-conducteur comportant un corps et une couche conductrice de l'électricité conformée suivant un motif et consistant en aluminium avec un faible pourcentage de vanadium sur une surface de ce corps, caractérisé en ce que la couche contient 0,01 à 0,3% en poids de vanadium qui se trouve réparti uniformément en solution solide dans la couche.

2. Dispositif suivant la revendication 1, caractérisé en ce que la couche ne contient pas plus de 0,13% en poids de vanadium.

3. Dispositif suivant la revendication 1 ou 2, caractérisé en ce que la couche contient jusqu'à 4% en poids de silicium.

4. Procédé pour fabriquer un dispositif semi-conducteur suivant la revendication 1, suivant lequel la couche conductrice de l'électricité consistant en aluminium avec un faible pourcentage de vanadium est déposée sur une surface de ce corps, après quoi la couche est rendue conforme au motif et recuite, caractérisé en ce que la couche est déposée par pulvérisation d'aluminium et de vanadium à partir d'une source unique de façon que la couche telle qu'elle est déposée contienne 0,01 à 0,3% en poids de vanadium et en ce que la couche est recuite à une température de l'intervalle de 400°C à 500°C pendant une durée de l'intervalle de 10 minutes à 480 minutes.

**Patentansprüche**

1. Halbleiteranordnung mit einem Körper, auf dessen Oberfläche eine mit einem Muster versehene elektrisch leitende Schicht vorgesehen ist, die aus Aluminium mit einem geringen Vanadiumgehalt besteht, dadurch gekennzeichnet, daß die Schicht 0,01 - 0,3 Gew.% Vanadium aufweist, das in fester Lösung einheitlich über die Schicht verteilt ist.

2. Anordnung nach Anspruch 1, dadurch gekennzeichnet, daß die Schicht mehr als 0,13 Gew.% Vanadium aufweist.

3. Anordnung nach Anspruch 1 oder 2, dadurch gekennzeichnet, daß die Schicht bis zu 4 Gew.% Silizium aufweist.

4. Verfahren zum Herstellen einer Halbleiteranordnung nach Anspruch 1, wobei die elektrisch leitende Schicht aus Aluminium mit einem geringen Prozentsatz Vanadium auf einer Oberfläche des genannten Körpers angebracht wird, wonach die Schicht mit einem Muster versehen und geglüht wird, dadurch gekennzeichnet, daß die Schicht durch Zerstäubung von Aluminium und Vanadium aus einer einzigen Quelle derart angebracht wird, daß die angebrachte Schicht 0,01 - 0,3 Gew.% Vanadium aufweist und daß die Schicht während einer Zeit im Bereich von 10 Minuten bis 480 Minuten bei einer Temperatur im Bereich von 400°C bis 500°C geglüht wird.

FIG.1

FIG.2a

FIG.2b

FIG.2c

FIG.2d

FIG.3a

FIG.3b